# EUROPEAN PATENT APPLICATION

(11) **EP 2 180 527 A1**
(43) Date of publication of application: **28.04.2010**
(21) Application number: 08167288.3
(22) Date of filing: 22.10.2008
(51) Int. Cl.: H01L 31/052

(54) **Semiconductor device and method of producing a semiconductor device**

(71) Applicant: Applied Materials, Inc., Santa Clara, CA 95054 (US)
(72) Inventor: Straub, Axel, 55218, Ingelheim (DE)
(74) Representative: Lermer, Christoph

(57) **Abstract**

A photovoltaic module 1 is a glass-glass thin film solar cell. It comprises a transparent glass substrate 2 arranged on the front side of the module 1, i.e. in the direction of the light source. A layer system 3 is deposited on the substrate which comprises a front electrode layer 4, e.g. a TCO layer, an active semiconductor layer 5 and a second electrode layer 6, which may also be a TCO (transparent conductive oxide) layer. The active semiconductor layer 5 comprises semiconducting areas of different conductivity type and a junction between these areas. The junction may be a p-n or a p-i-n junction between a p-doped area and an n-doped area. The layer system 3 is sandwiched between the glass substrate 2 and a glass encapsulation element 7. The glass encapsulation element 7 is bonded to the substrate 1 and the layer system 3, respectively, by means of a bonding layer 8. According to the invention the bonding layer 8 is configured as a white lambertian back reflector. It may consist of a PVB (poly vinyl butyral) or a silicone material layer and an appropriate dye or pigment, e.g. titanium-dioxide, embedded in the PVB or silicone material layer.

## Description

### TECHNICAL FIELD

The present invention relates to a semiconductor device, particularly a solar cell module, comprising: a transparent substrate arranged at a front side of the semiconductor device; a layer system comprising at least an electrode layer deposited on the substrate, at least a thin film semiconductor layer;, a back encapsulation element arranged at the back side of the semiconductor device; and a bonding material layer for bonding the back encapsulation element to the substrate, wherein the bonding material layer is arranged between the layer system and the back encapsulation element. Furthermore, the present invention relates to a method of producing a semiconductor device, particularly a semiconductor device as described above, comprising the steps of: a) providing a substrate; b) depositing a layer system on the substrate, wherein the layer system comprises at least an electrode layer deposited on the substrate, at least a thin film semiconductor layer; and c) fixing a back encapsulation element on the substrate.

### PRIOR ART

Due to high prizes for fossil energy and environmental pollution the demand for photovoltaic devices or solar cell modules increases permanently. Generally, solar cell modules convert light impinging on the solar cell into electric energy. Solar cell modules comprise at least a first electrode layer, a thin film semiconductor layer deposited on the first electrode layer, and at least a second electrode layer. The thin film semiconductor layer includes at least two semiconducting areas of different conductivity type and a junction between these areas. The junction may be a p-n or a p-i-n junction between a p-doped area and an n-doped area. In the semiconductor layer the conversion of light into energy takes place. The electrode layers are configured as contacts for extracting the energy from the layer system.

In the development of solar cells it has always been an aim to increase the efficiency the conversion efficiency. To this end a number of measures have been taken like selecting suitable materials, etc..

An obvious source for the loss of efficiency is caused by light transmitting through the active semiconductor layer of the solar cell module. In order to prevent a high transmission rate reflectors have been arranged on the back side of solar cell modules in order to reflect the transmitted light back into the active semiconductor layer thereby increasing the efficiency of the solar cell module considerably.

Usually, in conventional technology a reflective metallic film layer has been produced on the back side of the solar cell. However, metallic film layers are sensitive to moisture and oxidation. Furthermore, a metal deposition step is required to produce the reflective layer. This involves quite high production costs of the reflective layer.

Document DE 43 37 694 A1 discloses another reflector having high reflexivity which is a layer comprising a binder and white pigments, e.g. barium sulfate, titan oxide and zink sulfide. The white dielectric layer causes light transmitting through the active semiconductor layer to be reflected efficiently. The reflector is produced on one side of a glass element using white paint, white resin or similar materials with titanium dioxide embedded therein.

For modules which are encapsulated using EVA (ethyl-vinyl-acetate) or tedlar foils, a white tedlar foil proved to be beneficial for the performance of a module due to the reflective properties.

### OBJECT OF THE INVENTION

It is an object of the present invention to provide a semiconductor device, particularly a solar cell module, having high efficiency at reduced manufacturing costs.

### TECHNICAL SOLUTION

This object is solved by providing a semiconductor device according to claim 1 and a method of producing a semiconductor device according to claim 9. The dependent claims refer to preferred features of the invention.

A semiconductor device, particularly a solar cell module, according to the present invention comprises: a transparent substrate arranged at a front side of the semiconductor device; a layer system having at least a thin film semiconductor layer, and at least an electrode layer deposited on the thin film semiconductor layer; a back encapsulation element arranged at the back side of the semiconductor device; and a bonding material layer for bonding the back encapsulation element to the substrate, wherein the bonding layer is arranged between the first layer system and the encapsulation element. The bonding material layer is configured as a reflective layer for reflecting light transmitted through the layer system.

The invention relates particularly to glass- glass thin film solar cell modules. Usually, the transparent substrate of this type of solar cell modules is a glass substrate, and the back encapsulation element is another glass element. The back encapsulation element encapsulates the layer system of the thin film solar cell module between the glass substrate and the back encapsulation element. The electrode layers and the semiconductor layer(s) may include a plurality of layers, i.e. a layer stack sandwiched between this substrate and the back encapsulation layer.

The substrate is arranged at the front side, i.e. the side facing the light source (usually the sun), whereas the back encapsulation element is arranged at back side of the module, i. e. the side of the layer/ electrode system opposite the light source.

According to the invention the bonding material layer used for bonding the back encapsulation element to the substrate is configured as a reflector element reflecting light transmitted through the layer system back into the thin film semiconductor layer. Therefore, the bonding material may comprise a bonding material, an adhesive or glue, etc., as a carrier material and reflective material/ reflective particles/ white colour/ white dye embedded in the carrier material.

When producing a solar cell module according to the present invention an additional step of arranging a reflective layer on top of at least one of the surfaces of the back encapsulation element may be abolished thereby decreasing the production costs of the solar cell module.

The reflective layer comprises PVB (poly vinyl butyral) as a bonding material. The PVB layer may be configured as a white lambertian reflector.

In another preferred embodiment of the invention the reflective layer comprises silicone as a bonding material between the front substrate (glass) and the back encapsulation layer (glass).

Particularly, the reflective layer comprises pigments and/or dye, particularly white pigments and/or white dye, particularly white titanium dioxide, which may be embedded in the bonding material.

In a preferred embodiment of the invention the transparent substrate and/ or the back encapsulation element are glass elements.

Particularly, the layer system may comprise a second electrode layer, wherein the first electrode layer and/ or the second electrode layer are (semi) transparent electrode layers. Especially the second electrode layer may be a front electrode layer which has to be more or less transparent in order to allow the light impinging the solar cell module to pass into the active layer system. Alternatively, in case the solar cell is contacted completely from the back side, there may be no front electrode layer provided.

Generally, the present invention refers to applying a back reflector without an additional process step as the back reflector is applied during the lamination process.

In a preferred embodiment of the invention the reflective layer is configured as a lambertian reflector. The surface luminance of lambertian reflectors is substantially isotropic. It is particularly preferred that the reflective layer is a white lambertian reflector, i.e. the layer comprises white pigments and / or is white coloured.

In accordance with the invention a method of producing a semiconductor device, particularly a semiconductor device as described above, comprises as steps of: a) providing a substrate; b) depositing a layer system having at least a thin film semiconductor layer, and at least an electrode layer deposited on the thin film semiconductor layer; c) fixing an encapsulation element on the back side of the semiconductor element by means of a bonding or adhesive material which is configured as reflective layer. The process is particularly compatible with glass-glass thin film photovoltaic modules.

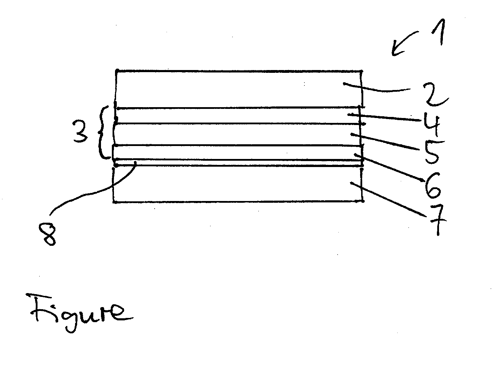

### BRIEF DESCRIPTION OF THE DRAWING

Further features and advantages of the invention will be apparent from the following description of preferred embodiment with reference to the appended drawing. The figure illustrates an embodiment of a semiconductor device according to the present invention.

### DETAILED DESCPRIPTION OF A PREFERRED EMBODIMENT

The figure illustrates a first embodiment of a photovoltaic module 1 according to the present invention.

The photovoltaic module 1 comprises a transparent glass substrate 2 arranged on the front side of the module 1. On the back side of the substrate 2 a layer system 3 is deposited which comprises a front electrode layer, e.g. a TCO (transparent conductive oxide) layer 4, an active semiconductor layer 5 and a second electrode layer 6, which may also be a TCO (transparent conductive oxide) layer. The active semiconductor layer 5 comprises at least two semiconducting areas of different conductivity type and a junction between these areas. The junction may be a p-n or a p-i-n junction between a p-doped area and an n-doped area. The invention includes, however, solar cells having any junction which may convert light into an electric current. For example, so called Tandem junction solar cells may be used in connection with the invention. An example for a tandem junction solar cell comprises a stack of amorphous silicon and a stack of microcrystalline silicon, both of them forming a p-i-n junction. The p-i-n junctions are interconnected in series by a tunnel junction.

According to the present invention the photovoltaic module 1 is a glass-glass thin film solar cell, wherein the layer system 3 is sandwiched between the glass substrate 2 and a glass encapsulation element 7. The glass encapsulation element 7 is bonded to the substrate 1 and the layer system 3, respectively, by means of a bonding layer 8.

According to the invention the bonding layer 8 is configured as a white lambertian back reflector. In particular it consists of a reflective PVB (poly vinyl butyral) material layer which acts as a bonding/ adhesive material. An appropriate dye or pigment, e.g. titanium-dioxide, is embedded in the PVB material layer 8 such that the PVB layer 8 acts as a white lambertian back reflective layer.

Due to the fact that the bonding layer 8 is a reflective layer an additional production step of providing a reflective layer may be abandoned, thereby increasing the cost effectiveness of the photovoltaic module 1.

## Claims

1. A semiconductor device (1), particularly a solar cell module, comprising:
a transparent substrate (2) arranged at a front side of said semiconductor device (1);
a layer system (3) comprising at least a thin film semiconductor layer (5), and at least an electrode layer (6) deposited on said thin film semiconductor layer (5);
a back encapsulation element (7) arranged at a back side of said semiconductor device (1); and
a bonding material layer (8) for bonding said back encapsulation element (7) to said substrate (2), wherein said bonding material layer (8) is arranged between said layer system (3) and said encapsulation element (7),
**characterized in that**
said bonding material layer (8) is configured as a reflective layer for reflecting light transmitted through the layer system (3).

2. The semiconductor device (1) of claim 1, **characterized in that**
said reflective layer comprises bonding material and pigments and/or dye.

3. The semiconductor device (1) of any of the previous claims, **characterized in that** said reflective layer comprises PVB (poly vinyl butyral) as a bonding material.

4. The semiconductor device (1) of any of the previous claims, **characterized in that** said reflective layer comprises silicon as a bonding material.

5. The semiconductor device (1) of any of the previous claims, **characterized in that** said reflective layer comprises white pigments and/or white dye, particularly titanium dioxide.

6. The semiconductor device (1) of any of the previous claims, **characterized in that** said reflective layer is a lambertian reflector.

7. The semiconductor device (1) of any of the previous claims, **characterized in that** said substrate (2) and/ or said encapsulation element (7) are glass elements.

8. The semiconductor device (1) of any of the previous claims, **characterized in that** said layer system comprises a second electrode layer (4), wherein said second electrode layer (4) and/ or said electrode layer (6) are (semi)transparent electrode layers.

9. A method of producing a semiconductor device (1), particularly a semiconductor device (1) according to any of the previous claims, comprising the steps of:
a) providing a substrate (2);
b) depositing a layer system (3) on said substrate (2), wherein said layer system (3) comprises at least a semiconductor layer (5), and at least an electrode layer (6);
c) fixing an encapsulation element (7) to said substrate (2),
**characterized in that**
said encapsulation element (7) is fixed to said substrate (2) by means of a bonding layer (8) which is configured as a reflective layer.

10. The method of claim 9, **characterized in that**
said bonding layer (8) comprises a bonding material and white pigments and/or white dye.

11. The method of any of the previous claims 9 to 10, **characterized in that**
said reflective layer comprises PVB (poly vinyl butyral) as a bonding material.

12. The method of any of the previous claims 9 to 11, **characterized in that**
said reflective layer comprises silicon as a bonding material.

13. The method of any of the previous claims 9 to 12, **characterized in that**
said reflective layer comprises white titanium dioxide.

14. The method of any of the previous claims 9 to 13, **characterized in that**
said substrate (2) and/ or said encapsulation element (7) are glass elements.

15. The method of any of the previous claims 9 to 14, **characterized in that**
said reflective layer is a lambertian reflector.

## Amended claims

### Amended claims in accordance with Rule 137(2) EPC.

**1.** A semiconductor device (1), particularly a solar cell module, comprising:
a transparent substrate (2) arranged at a front side of said semiconductor device (1);
a layer system (3) comprising at least a thin film semiconductor layer (5), and at least an electrode layer (6) deposited on said thin film semiconductor layer (5);
a back encapsulation element (7) arranged at a back side of said semiconductor device (1); and
a bonding material layer (8) for bonding said back encapsulation element (7) to said substrate (2), wherein said bonding material layer (8) is arranged between said layer system (3) and said encapsulation element (7),
**characterized in that**
said bonding material layer (8) is configured as a reflective layer for reflecting light transmitted through the layer system (3), and said bonding material layer (8) has a carrier material and reflective material, reflective particles white colour and/or white dye embedded in the carrier material.

**2.** The semiconductor device (1) of claim 1, **characterized in that**
said reflective layer comprises bonding material and pigments and/or dye.

**3.** The semiconductor device (1) of any of the previous claims, **characterized in that** said reflective layer comprises PVB (poly vinyl butyral) as a bonding material.

**4.** The semiconductor device (1) of any of the previous claims, **characterized in that** said reflective layer comprises silicone as a bonding material.

**5.** The semiconductor device (1) of any of the previous claims, **characterized in that** said reflective layer comprises white pigments and/or white dye, particularly titanium dioxide.

**6.** The semiconductor device (1) of any of the previous claims, **characterized in that** said reflective layer is a lambertian reflector.

**7.** The semiconductor device (1) of any of the previous claims, **characterized in that** said substrate (2) and/ or said encapsulation element (7) are glass elements.

**8.** The semiconductor device (1) of any of the previous claims, **characterized in that** said layer system comprises a second electrode layer (4), wherein said second electrode layer (4) and/ or said electrode layer (6) are transparent or semi-transparent electrode layers.

**9.** A method of producing a semiconductor device (1), particularly a semiconductor device (1) according to any of the previous claims, comprising the steps of:
a) providing a substrate (2);
b) depositing a layer system (3) on said substrate (2), wherein said layer system (3) comprises at least a semiconductor layer (5), and at least an electrode layer (6);
c) fixing an encapsulation element (7) to said substrate (2),
**characterized in that**
said encapsulation element (7) is fixed to said substrate (2) by means of a bonding layer (8) which is configured as a reflective layer and has a carrier material and reflective material, reflective particles, white colour and/or white dye embedded in the carrier material.

**10.** The method of claim 9, **characterized in that**
said bonding layer (8) comprises a bonding material and white pigments and/or white dye.

**11.** The method of any of the previous claims 9 to 10, **characterized in that**
said reflective layer comprises PVB (poly vinyl butyral) as a bonding material.

**12.** The method of any of the previous claims 9 to 11, **characterized in that**
said reflective layer comprises silicone as a bonding material.

**13.** The method of any of the previous claims 9 to 12, **characterized in that**
said reflective layer comprises white titanium dioxide.

**14.** The method of any of the previous claims 9 to 13, **characterized in that** said substrate (2) and/ or said encapsulation element (7) are glass elements.

**15.** The method of any of the previous claims 9 to 14, **characterized in that** said reflective layer is a lambertian reflector.
